(19) Europäisches Patentamt
European Patent Office
Office européen des brevets

(11) Veröffentlichungsnummer : **0 104 388**
**B1**

(12) # EUROPÄISCHE PATENTSCHRIFT

(45) Veröffentlichungstag der Patentschrift : **06.05.87**

(51) Int. Cl.[4] : **C 08 F 38/00**, H 01 L 31/02, H 01 L 29/28, H 01 B 1/12, H 01 M 4/60, G 02 F 1/17// C08L101/00, C08L49/00

(21) Anmeldenummer : **83107934.8**

(22) Anmeldetag : **11.08.83**

(54) **Reversibel oxidierbare bzw. reduzierbare Polymere mit Polyen-Einheiten, Verfahren zu ihrer Herstellung und ihre Verwendung.**

(30) Priorität : **01.09.82 DE 3232483**

(43) Veröffentlichungstag der Anmeldung : **04.04.84 Patentblatt 84/14**

(45) Bekanntmachung des Hinweises auf die Patenterteilung : **06.05.87 Patentblatt 87/19**

(84) Benannte Vertragsstaaten : **BE DE FR GB NL**

(56) Entgegenhaltungen :
**EP-A- 0 054 136**
**Die Akte enthält technische Angaben, die nach dem Eingang der Anmeldung eingereicht wurden und die nicht in dieser Patentschrift enthalten sind.**

(73) Patentinhaber : **BASF Aktiengesellschaft**
**Carl-Bosch-Strasse 38**
**D-6700 Ludwigshafen (DE)**

(72) Erfinder : **Naarmann, Herbert, Dr.**
**Haardtblick 15**
**D-6719 Wattenheim (DE)**
Erfinder : **Muench, Volker, Dr.**
**Luitpoldstrasse 114**
**D-6700 Ludwigshafen (DE)**
Erfinder : **Franz, Klaus-Dieter, Dr.**
**Insterburger Strasse 12**
**D-6233 Kelkheim (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 104 388 B1

Jouve, 18, rue St-Denis, 75001 Paris, France

**Beschreibung**

Es ist bekannt, daß man substituierte Acetylene, z. B. Phenylacetylen, zu substituierten Polyenen polymerisieren kann, die man durch Komplexierung mit Komplexierungsmitteln, wie Iod oder Arsenpentafluorid, in elektrisch leitfähige Systeme überführen kann. Im Gegensatz zum unsubstituierten Poly(acetylen), welches durch Komplexierung hochleitfähig wird (Synthetic Metals, Band 1, Heft 2, Seite 101 ff (1979/1980)), werden substituierte Poly(acetylene) durch Iod nur zu Systemen mit geringer elektrischer Leitfähigkeit oxidiert (Makromolekulare Chemie, Band 182, Seiten 165-176 (1981)). Weiterhin sind Komplexe des Poly(phenylacetylens) mit Elektronenakzeptoren, wie Tetracyanochinodimethan bekannt, die ebenfalls jedoch nur in geringem Maß elektrisch leitfähig sind (Y. Kuwane, T. Masuda und T. Higashimura, Polymer Journal, Band 12, Heft 6, Seiten 387 bis 391 (1980)).

Es ist weiterhin bekannt, daß der ungeradzahlige, alternierende $C_{13}$-Kohlenwasserstoff Phenalenyl :

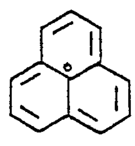

in 3 Oxidationsstufen auftreten kann (vgl. I. Murata, « Topics in Non-Benzoid Aromatic Systems », Vol. I, 159 (1976)). Bei « Störung » dieses $\pi$-Systems durch 1,9-Substitution bleibt die Fähigkeit des Systems, in mehreren Oxidationsstufen zu existieren, erhalten. So zeigen bestimmte Phenalene folgende Halbwerts- oder Halbstufenpotentiale ($E_{1/2}$) :

9-Hydroxy-1-phenalenon : $E_{1/2} = -0{,}95$ V
9-Methoxy-1-phenalenon : $E_{1/2} = -1{,}11$ V
9-(N-Methylamino)-1-phenalenon : $E_{1/2} = -1{,}27$ V
1-Ethoxy-9-(benzylthio) phenaleniumtetrafluorborat :

$$E_{1/2} = +0{,}1 \text{ V} ; E_{1/2} = -0{,}97 \text{ V}$$

Halbwerts- oder Halbstufenpotentiale sind in den gängigen Lehrbüchern der Elektrochemie definiert (vgl. z. B. « Organic Elektrochemistry », M.N. Baizer, M. Dekker, Verlag, New York, 1973).

Aufgabe der Erfindung war es, neue einfach herzustellende Polymere mit sehr guten anwendungstechnischen Eigenschaften und einer gesteigerten Verwendungsbreite, insbesondere im Gebiet der Elektrotechnik, zur Verfügung zu stellen. Die Polymere sollen insbesondere leicht und über einen längeren Zeitraum reproduzierbar ohne Produktschädigungen reversibel in mehrere Oxidationsstufen überführbar sein und sich mit üblichen Dotierungsmitteln in elektrisch hochleitfähige Systeme mit Leitfähigkeiten größer als $10^{-1}$ $\Omega^{-1}$ $cm^{1}$ unwandeln lassen und eine gute Stabilität gegenüber Luftsauerstoff haben.

Die Aufgabe der Erfindung wird gelöst durch Polyacetylen mit mindestens 5 konjugierten aliphatischen C-C-Doppelbindungen in der Polymerhauptkette, bestehend aus

(A) 0,1 bis 100 Mol-% wiederkehrenden Einheiten der allgemeinen Formeln (Ia) und (Ib)

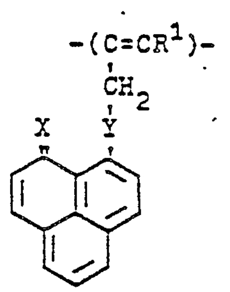 (Ia) , 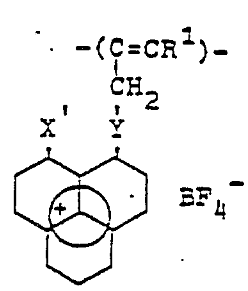 (Ib)

worin

$R^1$ H, $C_1$- bis $C_4$-Alkyl, $C_6$- bis $C_{12}$-Cycloalkyl oder Aryl ;
X O, S oder $NR^2$ ;
Y —O—, —S— oder $—NR^2—$ ;
X $—OR^2$, $—SR^2$ oder $—NR_2{}^2$, und
$R^2$ H, $C_1$- bis $C_4$-Alkyl, $C_6$- bis $C_{12}$-Cycloalkyl oder Benzyl

bedeuten, und

(B) 99,9 bis 0 Mol-% Polymereinheiten die durch Copolymerisation von Acetylen oder anderen Acetylenverbindungen erhalten wurden.

Weitere Lösungen der Aufgabenstellung sind die Verwendung der Polymeren in der Elektrotechnik zur Herstellung von Sonnenzellen, zur Umwandlung und Fixierung von Strahlung, zur Herstellung elektrischer Schalter und « electrochromic displays », zur Herstellung von Elektroden sowie die Verwendung der Polymeren als reversible Redoxsysteme und weiterhin die Verwendung der Polymeren zur antistatischen Ausrüstung von Kunststoffen.

Weitere Gegenstände der Erfindung ergeben sich aus der folgenden Beschreibung.

Die erfindungsgemäßen Polymeren können durch Polymerisation von Acetylen-verbindungen der allgemeinen Formeln (IIa) oder (IIb) erhalten werden.

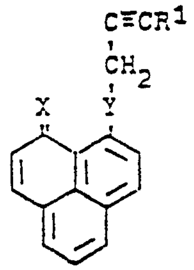 (IIa)

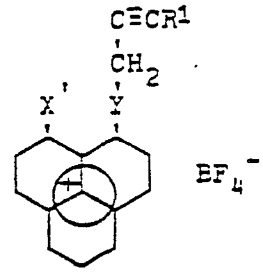 (IIb)

In diesen Formeln haben $R^1$, Y, X und X' die oben angegebenen Bedeutungen. Diese Monomoren können homopolymerisiert werden. Sie können auch untereinander copolymerisiert werden. Es ist auch möglich die Acetylenverbindungen der Formeln (IIa) oder (IIb) mit Acetylen oder anderen Acetylenverbindungen der Copolymerisation zu unterwerfen. Die Polymerisationsverfahren hierzu sind bekannt. So werden z. B. als Polymerisationsinitiatoren, Ziegler-Natta-Systeme oder Luttinger-Green-Katalysatoren verwendet. Die Polymerisation der Monomeren erfolgt zweckmäßig in Lösungsmitteln wie Toluol, Tetrahydrofuran, gegebenenfalls in Dimethylformamid, Ethanol oder Wasser. Die Polymerisation wird zweckmäßig im Temperaturbereich von —80 bis 50 °C vorgenommen. Solche Verfahren sind bekannt, sie sind z. B. in Angew. Chem., Int. Ed. 20 (1981), Seiten 361 bis 381, auf Seiten 364/365 beschrieben.

Die Acetylenverbindungen der Formeln IIa und IIb werden durch Umsetzung eines in 1,9-Stellung substituierten Phenalenderivats der allgemeinen Formel IIIa oder IIIb

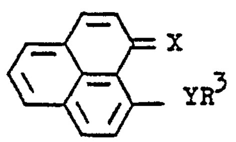 (IIIa)

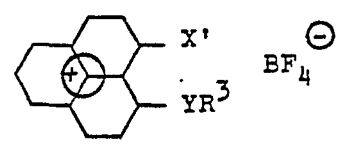 (IIIb)

worin X, X und Y die oben angegebene Bedeutung haben und $R^3$ gleich H, $C_1$- bis $C_4$-Alkyl, $C_6$- bis $C_{12}$-Cycloalkyl oder Benzyl sein kann, mit einem Acetylenderivat der allgemeinen Formel (IV) erhalten

$$HZ—CH_2—C \equiv CR^1, \qquad (IV)$$

worin Z = O, NH oder S sein kann und $R^1$ die oben angegebene Bedeutung besitzt.

Die Umsetzung der Phenalenderivate der Formeln IIIa und IIIb mit dem Acetylenderivat der Formel IV erfolgt zweckmäßig in aromatischen Kohlenwasserstoffen, Ethern oder Alkoholen wie Toluol, Tetrahydrofuran oder Dimethylformamid. Die Umsetzung erfolgt bei Temperaturen zwischen + 20 und 80 °C. Als Katalysatoren eignen sich Katalytische Mengen an Basen, wie tertiären Aminen z. B. Pyridin oder auch K-tert.-Butylat.

Die erfindungsgemäßen Polyene können mit üblicherweise verwendeten Komplexierungsmitteln komplexiert und in elektrisch hochleitfähige Systeme mit Leitfähigkeiten größer als $10^{-1}$ S/cm ($10^{-1}$ $\Omega^{-1}$ $cm^{-1}$) übergeführt werden. Geeignete Komplexierungsmittel sind beispielsweise : oxidierende Lewissäuren, wie z. B. $AsF_5$, $SbF_5$, $SbCl_5$, $VF_5$ oder $XeF_6$ ; oder nichtoxidierende Lewissäuren plus ein Oxidationsmittel, wie z. B. $PCl_5 + Cl_2$, $AlCl_3 + Cl_2$, $PF_5 + NOF$ ; oder oxidierende Protonensäuren, wie z. B. $HNO_3$, $H_2SO_4$ oder $H_2SeO_4$ ; oder nichtoxidierende Protonensäuren, welche durch anodische Oxidation eingelagert werden, wie z. B. $H_3PO_4$ oder $CF_3SO_3H$ ; oder Salze, welche durch anodische Oxidation eingelagert werden, wie z. B. $NaPF_6$ oder $NaBF_4$ ; oder stark elektropositive Metalle wie z. B. Li, Na, K, Rb, Cs, Mg, Ca, Sr, Ba, Lanthanid ; oder tertiäre oder quaternäre Ammoniumionen, welche

durch kathodische Reduktion eingelagert werden.

Dadurch werden Polymere erhalten, welche bei hoher elektrischer Leitfähigkeit ein verbessertes elektrochromes und elektrochemisches Verhalten sowie ein verbessertes Redoxverhalten aufweisen. Die komplexierten Polymere vereinen demnach die vorteilhaften Eigenschaften der Phenalene, wie z. B. intensive Farbe und elektrochromes Verhalten, mit den vorteilhaften Eigenschaften von dotiertem Poly(acetylen), wie z. B. hoher elektrischer Leitfähigkeit.

Die neuen leitfähigen Polymere können in der Elektrotechnik zur Herstellung von Sonnenzellen, zur Umwandlung und Fixierung von elektromagnetischen Strahlen, zur Herstellung elektrischer Schalter und « electrochromic displays » sowie zur Herstellung von Elektroden verwendet werden. Weitere Verwendung finden die erfindungsgemäßen Polymere als reversible Redoxsysteme oder zur antistatischen Ausrüstung von Kunststoffen.

## Beispiel 1

a) Darstellung von 3-N(Phenalen-1'-on-9'-yl amino)-propin-(1) [9-(Propargylamino)phenalen-1-on] der Formel :

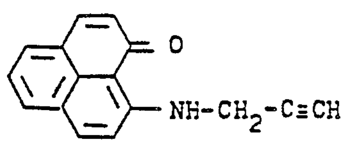

5 g 9-Butoxy-1-phenalenon (19,8 mmol) werden in 150 ml Chloroform gelöst und auf 65 °C erhitzt. Zur siedenden Lösung tropft man im Laufe von 7 min 5,46 g Propargylamin (6,43 ml ; 99 mmol). Dabei fallen geringe Mengen eines gelben Niederschlages aus. Man kocht 6 Stunden am Rückfluß und läßt langsam über Nacht abkühlen. Anschließend wird das Produkt mit 650 ml n-Hexan ausgefällt, abgesaugt und 5 h im Ölpumpenvakuum getrocknet.

Ausbeute : 2,65 g = 57,3 %, braungelbes Pulver ;
Fp. 179-181 °C (Zersetzung) ;
DC an Kieselgel 60 $F_{254}$ (Merck), Laufmittel Toluol/Ether 8 : 2, $R_f = 0,288$ ;
IR : (= C—H) 3 210 $cm^{-1}$, (C = C) 2 220 $cm^{-1}$ ;
1 H—NMR in $CDCl_3$ : $\sigma$ = 2,35 ppm (Tripletts 1 H, = C—H)
$\sigma$ = 4,35 ppm (Multiplett, 2 H, —$CH_2$—),
$\sigma$ = 7-8,15 ppm (Multiplett, 7 H, Phenalen)
Molgewicht massenspektrometrisch : 233 g
Formel laut Analyse : $C_{16}H_{11,5}O_{1,15}N_{1,04}$ ;
(Theorie : $C_{16}H_{11}ON$)

b) Polymerisation von 9-(Propargylamino)-phenalen-1-on : 1,5 g 9-(Propargylamino)-phenalen-1-on werden in 100 ml Ethanol aufgelöst und bei —40 °C mit Luttinger Kontakt ($Co(NO_3)_2/NaBH_4$, 0,5 g) versetzt. Man läßt die Lösung unter Rühren auf Raumtemperatur kommen. Dabei beginnt bei Erreichen von 0 °C die Polymerisation.

Ausbeute : 1,4 g Poly[3-(phenalen-1'-on-9'-yl) aminopropin-(1)],

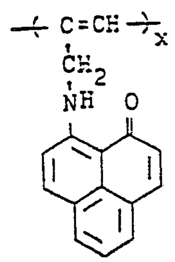

schwarzes Pulver, elektrische Leitfähigkeit $\sigma = 10^{-10}$ S/cm.

c) Komplexierung von Poly[3-(phenalen-1'-on-9'-yl) aminopropin-1)] :

c1) 0,5 g des Polymeren werden zu einer Tablette gepreßt. Diese Tablette wird in einer Elektrolysezelle als Anode geschaltet. Als Lösungsmittel dient Acetonitril, als Leitsalz Tetrabutylammoniumtetrafluorborat. Man erhält einen tiefblauen Komplex der Zusammensetzung $[(C_{16}H_{11}NO)\ (BF_4)_{0,21}]_x$ mit einer elektrischen Leitfähigkeit von $\sigma = 10^2$ S/cm.

c2) 0,5 g des Polymeren werden zwei Tage lang 0,5 bar $AsF_5$ ausgesetzt. Es entsteht ein Komplex der Zusammensetzung $[(C_{16}H_{11}NO)\ (AsF_5)_{0,12}]_x$ mit einer Leitfähigkeit von $\delta = 10^2$ S/cm.

d) Elektrochromes Verhalten :

Der tiefblaue Komplex $[(C_{16}H_{11}NO)\ (BF_4)_{0,21}]_x$ wird in einer Elektrolysezelle als Kathode geschaltet und reduziert. Dabei ändert sich die Farbe der Elektrode von tiefblau über hellbraun nach tiefdunkelbraun

($E_{1/2}$ = — 1 V).

In analoger Weise wurden beispielsweise synthetisiert :

| Beispiel Nr. | | Darstellung |
|---|---|---|
| 2 | 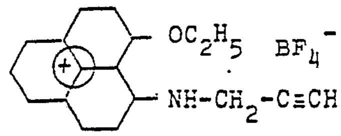 | aus 9-Butoxy-1-ethoxy-phenaleniumtetrafluorborat und Propargylamin |
| 3 | 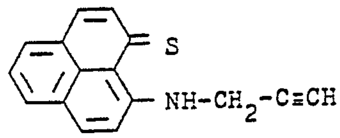 | aus 9-Butoxy-1-thio-phenalenon und Propargylamin |
| 4 | 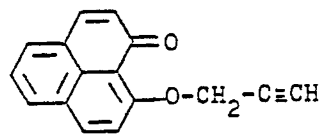 | aus 9-Butoxy-1-phenalenon und Propargylalkohol |
| 5 | 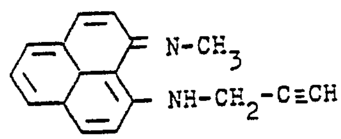 | aus 1-(N-Methylimino)-9--butoxy-1-phenalenon und Propargylamin |
| 6 | 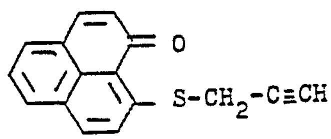 | aus 9-N-Pyrrolidino-1-phenalenon und Propargylthiol |

Die Eigenschaften der hieraus hergestellten Polymeren sind in der folgenden Tabelle wiedergegeben.

Tabelle

| Polymeres aus Nr. | el. Leitf. σ (S/cm) | Komplex mit Iod Aufnahme mol-% pro Monomereinheit | el. Leitf. des Iod-Komplexes σ (S/cm) |
|---|---|---|---|
| 2 | $10^{-6}$ | 0,3 | 10°C |
| 3 | $10^{-8}$ | 0,75 | $10^{2}$ |
| 4 | $10^{-11}$ | 0,63 | $10^{2}$ |
| 5 | $10^{-9}$ | 0,8 | $10^{3}$ |
| 6 | $10^{-8}$ | 0,61 | $10^{2}$ |

## Patentansprüche

1. Polyacetylen mit mindestens 5 konjugierten aliphatischen C-C-Doppelbindungen in der Polymerhauptkette, bestehend aus

(A) 0,1 bis 100 Mol.-% wiedekehrenden Einheiten der allgemeinen Formel (Ia) und/oder (Ib)

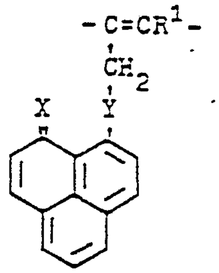

(Ia)

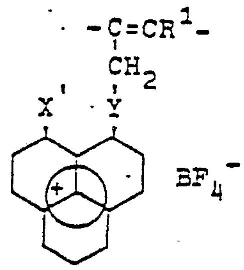

(Ib)

worin

$R^1$ H, $C_1$- bis $C_4$-Alkyl, $C_6$- bis $C_{12}$-Cycloalkyl oder Aryl

X O, S oder $NR^2$

X' $—OR^2$, $—SR^2$ oder $—NR_2^2$ ;

Y —O—, —S—, oder $—NR^2—$ ; und

$R^2$ H, $C_1$- bis $C_4$-Alkyl, $C_6$- bis $C_{12}$-Cycloalkyl oder Benzyl

bedeuten und

(B) 99,9 bis 0 Mol-% Polymereinheiten, die durch Copolymerisaten von Acetylen oder anderen Acetylenverbindungen erhalten würden.

2. Verfahren zur Herstellung von Polymeren nach Anspruch 1, dadurch gekennzeichnet, daß man Acetylenverbindungen der allgemeinen Formeln (IIa) und/oder (IIb)

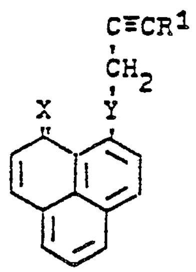

(IIa)

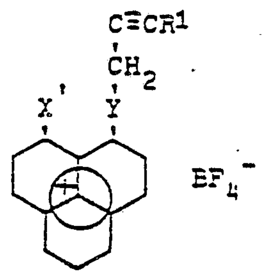

(IIb)

worin $R^1$, Y, X und X' die in Anspruch 1 wiedergegebene Bedeutung haben allein polymerisiert oder untereinander oder zusammen mit Acetylen oder anderen Acetylenverbindungen copolymerisiert.

3. Verwendung der Polymeren nach Anspruch 1 in der Elektrotechnik zur Herstellung von Sonnenzellen, zur Umwandlung und Fixierung von elektromagnetischen Strahlen, zur Herstellung elektrischer Schalter und « electochromic displays » sowie zur Herstellung von Elektroden.

4. Verwendung der Polymeren nach Anspruch 1 als reversible Redoxsysteme.

5. Verwendung der Polymeren nach Anspruch 1 zur antistatischen Ausrüstung von Kunststoffen.

**Claims**

1. A polyacetylene having at least 5 conjugated aliphatic C-C double bonds in the polymer main chain, and consisting of

(A) from 0.1 to 100 mol% of recurring units of the general formulae (Ia) and/or (Ib)

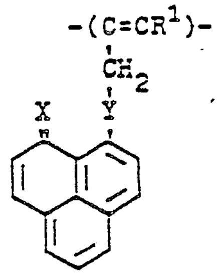

(Ia)

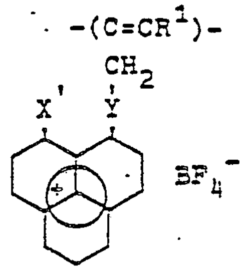

(Ib)

where

$R^1$ is H, $C_1$-$C_4$-alkyl, $C_6$-$C_{12}$-cycloalkyl or aryl,

X is O, S or $NR^2$,

X' is $—OR^2$, $—SR^2$ or $—NR_2^2$ ,

Y is —O—, —S— or $—NR^2—$ ; and

$R^2$ is H, $C_1$-$C_4$-alkyl, $C_6$-$C_{12}$-cycloalkyl or benzyl, and

(B) from 99.9 to 0 mol% of polymer units obtained by copolymerizing acetylene or other acetylenic compounds.

2. A process for the preparation of a polymer as claimed in claim 1, wherein acetylenic compounds of the formulae (IIa) and/or (IIb)

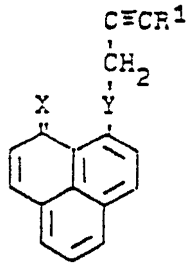 (IIa)

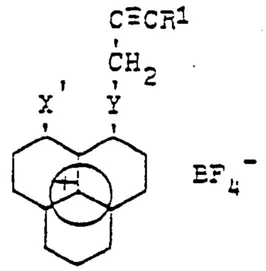 (IIb) ,

where $R^1$, Y, X and X′ have the meanings given in claim 1, are polymerized on their own or copolymerized with one another or together with acetylene or other acetylenic compounds.

3. The use of a polymer as claimed in claim 1 in electrical engineering for the production of solar cells, for the conversion and fixation of electromagnetic radiation, for the production of electric switches and electrochromic displays, and for the production of electrodes.

4. The use of a polymer as claimed in claim 1 as a reversible redox system.

5. The use of a polymer as claimed in claim 1 for the antistatic finishing of plastics materials.

**Revendications**

1. Polyacétylène avec au moins 5 doubles liaisons C-C aliphatiques conjuguées dans la chaîne principale du polymère, constitué par

(A) 0,1 à 100 moles % d'unités répétitives répondant à la formule générale (Ia) et/ou (Ib)

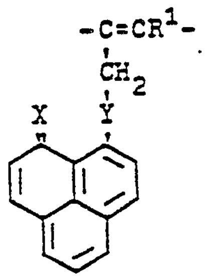 (Ia)

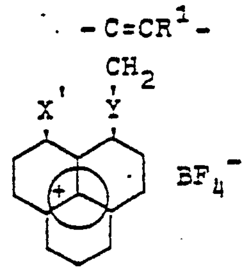 (Ib)

dans lesquelles les symboles représentent :

$R^1$ : H, un groupe alkyle en $C_1$ à $C_4$, un groupe cycloalkyle en $C_6$ à $C_{12}$ ou un groupe aryle

X : O, S ou $NR_2$

X′ : $—OR^2$, $—SR^2$ ou $—NR_2^2$ ;

Y : —O—, —S— ou $—NR^2—$ ; et

$R^2$ : H, un groupe alkyle en $C_1$ à $C_4$, un groupe cycloalkyle en $C_6$ à $C_{12}$ ou un groupe benzyle, et

(B) 99,9 à 0 mole % d'unités de polymères qui ont été obtenus par copolymérisation de l'acétylène ou d'autres composés acétyléniques.

2. Procédé pour la préparation de polymères selon la revendication 1, caractérisé en ce que les composés acétyléniques répondant aux formules générales (IIa) et/ou (IIb)

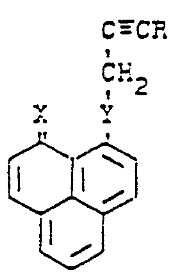 (IIa)

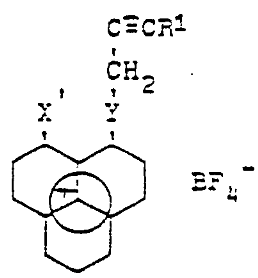 (IIb)

dans lesquelles $R^1$, Y, X et X' répondent aux définitions de la revendication 1, sont polymérisés seuls ou entre eux ou copolymérisés en commun avec de l'acétylène ou d'autres composés acétyléniques.

3. Utilisation des polymères selon la revendication 1 dans le domaine de l'électrotechnique, pour l'obtention de cellules solaires, pour la transformation et la fixation de faisceaux électromagnétiques, pour la fabrication de commutateurs électriques et d'affichages électrochromiques ainsi que pour la préparation d'électrodes.

4. Utilisation des polymères selon la revendication 1 comme systèmes redox réversibles.

5. Utilisation des polymères selon la revendication 1 pour le traitement antistatique des matières plastiques.